## Europäisches Patentamt
## European Patent Office
## Office européen des brevets

(11) Veröffentlichungsnummer: **0 271 072 B1**

## (12) EUROPÄISCHE PATENTSCHRIFT

(45) Veröffentlichungstag der Patentschrift: **30.10.91**

(51) Int. Cl.5: **H01L 21/225**, H01L 21/316

(21) Anmeldenummer: **87118186.3**

(22) Anmeldetag: **08.12.87**

Die Akte enthält technische Angaben, die nach dem Eingang der Anmeldung eingereicht wurden und die nicht in dieser Patentschrift enthalten sind.

(54) **Verfahren zum Erzeugen einer definierten Arsendotierung in Siliziumhalbleitersubstraten.**

(30) Priorität: **11.12.86 DE 3642412**

(43) Veröffentlichungstag der Anmeldung:
**15.06.88 Patentblatt 88/24**

(45) Bekanntmachung des Hinweises auf die Patenterteilung:
**30.10.91 Patentblatt 91/44**

(84) Benannte Vertragsstaaten:
**AT BE CH DE FR GB IT LI LU NL SE**

(56) Entgegenhaltungen:
**EP-A- 0 204 182**
**DD-A- 236 619**
**GB-A- 1 398 952**

**INTERNATIONAL ELECTRON DEVICES MEE-TING, TECHNICAL DIGEST, 1st-4th December 1985, pages 702-705, Washington, US; K. YA-MADA et al.: "A deep-trenched capacitor technology for 4 Mega bit dynamic RAM"**

(73) Patentinhaber: **SIEMENS AKTIENGESELL-SCHAFT**
**Wittelsbacherplatz 2**
**W-8000 München 2(DE)**

(72) Erfinder: **Treichel, Helmuth**
**Waldishoferstrasse 4**
**W-8900 Augsburg(DE)**
Erfinder: **Becker, Frank S., Dr.**
**Neufriedenheimer Strasse 67a**
**W-8000 München 70(DE)**

**Beschreibung**

Die Erfindung betrifft ein Verfahren zur Erzeugung einer definierten Arsendotierung in Siliziumhalbleitersubstraten, vorzugsweise in Seitenwänden und Böden von in die Substrate geätzten Gräben mit hohem Aspektverhältnis, wobei als Diffusionsquelle eine in diesen Gräben abgeschiedene Arsenosilikatglasschicht verwendet wird, die nach der Diffusion entfernt wird.

Bei der Entwicklung höchstintegrierter Schaltungen, beispielsweise den 4 Mega-Bit-Dynamic RAM, werden bei den Kondensatorspeicherzellen die planaren Zellen zunehmend wegen ihres größeren Platzbedarfs durch Grabenzellen ersetzt.

Um die Packungsdichte der Speicherzellen weiter zu erhöhen und dabei die Speicherkapazität beizubehalten werden Gräben mit einem hohen Aspektverhältnis größer gleich 3 ( = Verhältnis von Tiefe des Grabens zu Breite) erzeugt. Weiterhin ist ein genau kontrolliertes steiles $n^+$-Dotierprofil mit geringer Eindringtiefe erforderlich, um Leckströme zu benachbarten Speicherzellen zu vermeiden und eine hohe Verläßlichkeit der Schaltung zu gewährleisten.

Bei hohem Aspektverhältnis solcher Gräben hat sich zur Dotierung der Seitenwände und Böden die Ausdiffusion (Drive-in) aus dort abgeschiedenen dotierten Glasschichten (Diffusionsquelle) bewährt. Dadurch wird eine gleichmäßigere Dotierung erzielt und die Abnahme der Dotierstoffkonzentration in Richtung Grabenboden verringert.

Als Dotierstoff zur Erzeugung von Leitfähigkeitsbereichen des $n^+$-Typs wird Arsen bevorzugt. Dessen gegenüber Phosphor um den Faktor 4 geringere Diffusionslänge ermöglicht kleinere Abstände der Gräben.

Eine Methode zur Erzeugung einer Arsendotierung durch Ausdiffusion aus dotierten Glasschichten ist aus einem Artikel von K. Yamada et al in IEDM Technical Digest 1985, Seiten 702 bis 708, bekannt. In einem LPCVD ( = low pressure chemical vapour deposition)-Reaktor wird eine Arsenosilikatglasschicht (AsSG) durch thermische Zersetzung von Triethylarsenit As $(OC_2H_5)_3$ (TEAsit) und Tetraethylorthosilikat ( = TEOS = Si $(OC_2H_5)_4$) erzeugt und in einem Hochtemperaturschritt in das Substrat eingetrieben.

Nachteil dieser Methode ist ein relativ zur erreichbaren Stärke der Dotierung zu hoher Materialverbrauch bei gleichzeitig hohen Materialkosten. Die dabei anfallenden Zersetzungsprodukte erfordern eine häufige Reinigung von Filtern, Pumpen und anderen Vakuumteilen und werfen wegen ihrer Giftigkeit (arsenhaltig) weitere Probleme auf.

Als Folge der häufig notwendigen Reinigungen erhält man einen niedrigen Durchsatz der LPCVD-Anlage pro Zeiteinheit, der sich ebenfalls in hohen Kosten niederschlägt.

Außerdem ist es zur Erreichung eines steilen Dotierungsprofils nötig, eine Vorbehandlung des Substrats vorzunehmen und beim Hochtemperaturdiffusionsprozeß ( = drive-in) eine exakte Atmosphärenzusammensetzung einzustellen.

Aufgabe der vorliegenden Erfindung ist es, ein Verfahren zur Erzeugung einer definierten Arsendotierung anzugeben, das die oben erwähnten Nachteile nicht aufweist, also kostengünstig ist, weniger Entsorgungsprobleme aufwirft und beim drive-in eine geringere Abhängigkeit von den Verfahrensparametern zeigt.

Diese Aufgabe wird erfindungsgemäß dadurch gelöst, daß bei einem Verfahren der eingangs genannten Art die AsSG-Schicht durch thermische Zersetzung aus der Gasphase von TEOS (Si-$(OC_2H_5)_4$) und Triethylarsenat ( = AsO $(OC_2H_5)_3$ = TEAsat) abgeschieden wird.

Weiterhin liegt es im Rahmen der Erfindung, daß die AsSG-Schicht bei 650 bis 750 °C abgeschieden wird, wobei ein Druck von 0,5 bis 1,1 mbar eingestellt und den Reaktionsgasen Sauerstoff beigemischt wird.

Weitere Ausgestaltungen der Erfindung ergeben sich aus den Unteransprüchen.

Mit dem erfindungsgemäßen Verfahren wird der Verbrauch an Arsenverbindung pro gefahrenem Prozeß auf 1/10 des Wertes reduziert, der bei Verwendung von TEAsit erforderlich ist. Bei gleichem Preis pro Gramm Arsenverbindung für TEAsit und TEAsat werden so allein die Materialkosten um den Faktor 10 verringert.

Da der Durchsatz arsenhaltiger Zersetzungsprodukte stark verringert ist, verlängern sich als Folge die Intervalle zur Entsorgung der Anlage, wie zum Beispiel Reinigung der Filter usw. Die Umweltbelastung mit arsenhaltigen Zersetzungsprodukten wird stark reduziert.

Auch am Produkt werden mit dem erfindungsgemäßen Verfahren deutliche Verbesserungen erzielt. Bei gleichmäßiger Arsenverteilung in der AsSG-Schicht beträgt die Arsenkonzentration 2 bis 8 Gewichtsprozent Arsen (gegenüber ca. 5 % Arsen bei den bekannten Verfahren).

Weiterhin zeigt das 5-wertige Arsen ein verbessertes Diffusionsverhalten. Das Dotierprofil wird steiler und gleichzeitig die Totalkonzentration von Arsen an der Substratoberfläche erhöht. Bis ca. 150 Nanometer Eindringtiefe bleibt die hohe Arsenkonzentration erhalten (größer $10^{20}$ Atome pro $cm^3$) und fällt dann steil ab. Dabei ist die Einstellung dieses Profils kaum mehr von der Kombination Vorbehandlung und drive-in Atmosphäre abhängig.

Eine Verbesserung der Betriebssicherheit der Anlage ergibt sich aus dem gegenüber TEAsit niedrigeren Dampfdruck von TEAsat, der die Gefahr einer Vergiftung bei unbeabsichtigtem Öffnen des Verdampfers oder sonstigem Austreten von TEAsat verringert.

Im folgenden wird die Erfindung anhand eines Ausführungsbeispiels und der Figuren 1 bis 3 näher erläutert. In allen Figuren gelten dabei für gleiche Teile gleiche Bezugszeichen.

Dabei zeigt

Figur 1    einen Graben in einem Siliziumsubstrat, der ein hohes Aspektverhältnis aufweist,

Figur 2    zeigt diesen Graben mit einer darin abgeschiedenen Arsenosilikatglasschicht, während in

Figur 3    der Graben nach der Diffusion dargestellt ist, und die Silikatglasschicht bereits entfernt ist.

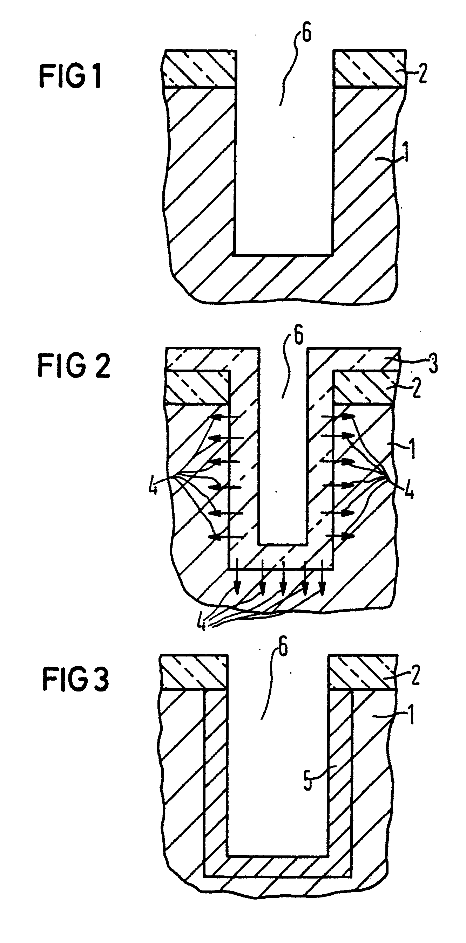

Figur 1 zeigt einen in ein mit einer Siliziumoxidschicht 2 bedecktes aus Silizium bestehendes Substrat 1 geätzten Graben 6 von beispielsweise 1 $\mu$m Breite und 3 $\mu$m Tiefe.

In einer Heißwand-Horizontal-LPCVD-Anlage werden nun die diese Gräben (6) enthaltenden Substratscheiben 1, 2 auf offenen Booten (Scheibenabstand ca. 4 mm) durch Zersetzung von TEOS und TEAsat mit der Arsenosilikatglasschicht belegt.

Figur 2 zeigt die Anordnung mit der AsSG-Schicht 3, die typischerweise bei einer mittleren Temperatur von 710$^\circ$ C und einem Druck von 920 mbar abgeschieden wird. Der Gastransport wird über die Trägergase $O_2$ für TEOS und $N_2$ für TEAsat geregelt, wobei über die Temperatur des TEAsat-Verdampfers der Arsengehalt der AsSG-Schicht 3 auf Werte von 2 bis 8 Gewichtsprozent Arsen eingestellt werden kann. Durch die Sauerstoffzumischung wird eine hohe Schichtgleichmäßigkeit erreicht.

Nähere Einzelheiten über den zur Abscheidung verwendeten Reaktor sind der europäischen Patentanmeldung EP-A-0 204 182 zu entnehmen.

Durch Erhitzen der Anordnung (1, 2, 3, 6) auf 1000$^\circ$ C wird eine Diffusion von Arsenatomen (siehe Pfeile 4) in das Substrat 1 erreicht. Nach einer Temperzeit von ca. 60 Minuten in einer 9:1 $N_2/O_2$ Atmosphäre ist der drive-in-Prozeß beendet.

Figur 3 zeigt den Graben 6 nach Entfernung der Schicht 3 mittels Naßätzung. Boden und Wände weisen nun eine definierte $n^+$-Dotierung mit einer Oberflächenkonzentration von größer $10^{20}$ Atome/cm$^3$ auf. Bis ca. 150 Nanometer Eindringtiefe bleibt der Arsengehalt nahezu gleich, um dann steil abzufallen. Dieses steile Dotierungsprofil ist nötig, um in der späteren Grabenzelle einen elektrischen Überschlag (punch-through) zu vermeiden.

Die erreichte Dotierung weist eine hohe Gleichmäßigkeit von ± 5 % über das gesamte Substrat auf. Diese Gleichmäßigkeit erstreckt sich auch über die gesamte Charge und ist reproduzierbar.

## Patentansprüche

1. Verfahren zur Erzeugung einer definierten Arsendotierung in Halbleitersubstraten, vorzugsweise in Seitenwänden und Böden von in die Substrate geätzten Gräben mit hohem Aspektverhältnis, wobei als Diffusionsquelle eine in diesen Gräben abgeschiedene Arsenosilikatglasschicht verwendet wird, die nach der Diffusion entfernt wird, **dadurch gekennzeichnet,** daß die Arsenosilikatglasschicht durch thermische Zersetzung aus der Gasphase von Tetraethylorthosilikat (Si $(OC_2H_5)_4$) und Triethylarsenat (AsO $(OC_2H_5)_3$) abgeschieden wird.

2. Verfahren nach Anspruch 1, **dadurch gekennzeichnet,** daß die Schicht bei 650 bis 750$^\circ$ C abgeschieden wird.

3. Verfahren nach Anspruch 1 oder 2, **dadurch gekennzeichnet,** daß die Schicht bei einem Druck von 0,5 bis 1,1 unbar abgeschieden wird.

4. Verfahren nach einem der Ansprüche 1 bis 3, **dadurch gekennzeichnet,** daß den zu zersetzenden Gasen Sauerstoff beigemischt wird.

## Claims

1. Method of producing a defined arsenic doping in semiconductor substrates, preferably in side walls and floors of trenches etched into the substrates and having a high aspect ratio, an arsenosilicate glass layer which is deposited in said trenches and removed after the diffusion being used as diffusion source, characterised in that the arsenosilicate glass layer is deposited by thermal decomposition from the gas phase of tetraethyl orthosilicate (Si $(OC_2H_5)_4$) and triethyl arsenate (AsO $(OC_2H_5)_3$).

2. Method according to Claim 1, characterised in that the layer is deposited at 650 to 750$^\circ$ C.

3. Method according to Claim 1 or 2, characterised in that the layer is deposited at a pressure of 0.5 to 1.1 mbar.

4. Method according to any of Claims 1 to 3, characterised in that oxygen is added to the gases to be decomposed.

## Revendications

1. Procédé pour produire un dopage défini d'arsenic dans des substrats semiconducteurs, de préférence dans des parois latérales et des fonds de sillons, formés par corrosion dans les substrats et possédant un taux d'élancement élevé, et selon lequel on utilise, comme source de diffusion, une couche de verre au silicate d'arsenic déposée dans ces sillons et qu'on élimine après la diffusion, caractérisé par le fait qu'on dépose la couche de verre à base de silicate d'arsenic par dissociation thermique à partir de la phase gazeuse d'orthosilicate de tétraéthyle (Si (OC$_2$H$_5$)$_4$) et d'arsenate de triéthyle (AsO (OC$_2$H$_5$)$_3$).

2. Procédé suivant la revendication 1, caractérisé par le fait qu'on dépose la couche entre 650 et 750° C.

3. Procédé suivant la revendication 1 ou 2, caractérisé par le fait qu'on dépose la couche à une pression comprise entre 0,5 et 1,1 mbar.

4. Procédé suivant l'une des revendications 1 à 3, caractérisé par le fait qu'on mélange de l'oxygène aux gaz devant être dissociés.

FIG 1

FIG 2

FIG 3